# DEMANDE DE BREVET EUROPEEN

(11) **EP 0 959 492 A1**
(43) Date de publication de la demande: **24.11.1999**
(21) Numéro de dépôt: 99401162.5
(22) Date de dépôt: 11.05.1999
(51) Int. Cl.: H01L 21/306, H01L 21/70, H01L 27/06, H01L 21/762, H01L 27/08, H01F 27/34, H01F 17/00

(54) **Procédé de formation de silicium poreux dans un substrat de silicium, en particulier pour l'amélioration des performances d'un circuit inductif**

(30) Priorité: 19.05.1998 FR 9806282
(71) Demandeur: STMicroelectronics SA, 94250 Gentilly (FR); FRANCE TELECOM, 75015 Paris (FR)
(72) Inventeur: Perea, Ernesto, 38330 Montbonnot (FR); Bomchil, Guillermo, 38180 Seyssins (FR); Halimaoui, Aomar, 38100 Grenoble (FR)
(74) Mandataire: Casalonga, Axel

(57) **Abrégé**

Pour notamment améliorer le coefficient de qualité d'un circuit inductif réalisé sur une plaquette semiconductrice (PL) de silicium incorporant également des transistors intégrés (T), on place la face arrière (FAR) de la plaquette incorporant déjà sur sa face avant lesdits transistors et le circuit inductif (L), au contact d'un électrolyte acide contenant de l'acide fluorhydrique et au moins un autre acide, et on effectue une oxydation anodique du silicium de la plaquette en face arrière de façon à transformer ce silicium en silicium poreux sur une hauteur prédéterminée (H2) depuis ladite face arrière (FAR) en contact avec ledit électrolyte.

## Description

L'invention concerne la formation de silicium poreux dans un substrat de silicium et s'applique avantageusement mais non limitativement à la réalisation des circuits inductifs réalisés de façon intégrée sur un substrat de silicium.

Les circuits inductifs sont un composant essentiel des circuits radiofréquence, particulièrement utilisés dans le domaine des téléphones portables. Un circuit inductif est un élément d'un circuit résonnant accordé inductif-capacitif.

Les circuits accordés inductifs-capacitifs sont notamment utilisés dans des amplificateurs radiofréquence accordés (amplificateurs radio-fréquence généralement passe-bande).

Un point particulièrement délicat de ces amplificateurs réside dans la sélectivité du circuit résonnant inductif-capacitif puisque, en dehors de la bande de fréquences utiles de l'amplificateur, toutes les autres composantes spectrales sont considérées comme du bruit. Classiquement, la réponse fréquentielle d'un amplificateur accordé inductif-capacitif comporte un pic centré sur la fréquence de résonance F0 (qui est égale à l'inverse de la racine carrée du produit de l'inductance par la capacité) et ayant une largeur à mi-hauteur communément désignée par Δf.

Le rapport F0/Δf est appelé le "coefficient de qualité" du circuit résonnant inductif-capacitif. (Dans la suite du texte, et par abus simplificateur de langage, on associera le terme de "coefficient de qualité" au circuit inductif seul). Ce coefficient de qualité doit être le plus grand possible. Or, la largeur Δf du pic de résonance est directement proportionnelle aux pertes énergétiques du circuit résonnant. En conséquence, plus les pertes sont importantes, plus le coefficient de qualité diminue.

Sur un substrat de silicium, les circuits inductifs sont réalisés en formant une spirale métallique reposant sur le silicium par l'intermédiaire d'une couche isolante, typiquement du dioxyde de silicium ayant par exemple une épaisseur de 1 micron. Or, contrairement aux substrats semiconducteurs en arseniure de Gallium (AsGa), les substrats silicium présentent une faible résistivité. Il en résulte par conséquent que le champ magnétique généré par la circulation du courant dans la spire métallique induit des courants de Foucault très élevés dans le substrat sous-jacent de silicium. Une part de l'énergie de ce champ magnétique va donc être dissipée sous forme de chaleur, abaissant par conséquent la valeur du coefficient de qualité.

Pour remédier à ce problème, il a été proposé notamment d'utiliser des circuits inductifs à haut coefficient de qualité, externes au circuit intégré comportant les autres éléments de l'amplificateur accordé. Ceci étant, une telle solution nécessite des composants et un support supplémentaires ce qui ne va pas dans le sens d'une économie de réalisation. En outre, des perturbations parasites peuvent gêner le bon fonctionnement de l'amplificateur en raison notamment des interconnexions entre le circuit intégré et le circuit inductif externe.

Il s'avère donc particulièrement avantageux de pouvoir disposer au sein d'un même circuit intégré, tous les composants de l'amplificateur radiofréquence et notamment tous les composants passifs tels que les inductances et les capacités. A cet égard, il a été proposé d'effectuer des retraits sélectifs localisés de substrat sous les zones d'inductance, par des attaques chimiques localisées, typiquement à l'aide d'hydroxyde de potassium (KOH). Ceci étant, outre le fait qu'une telle solution nécessite des masques spécifiques à infrarouge disposés sur la face arrière du substrat, et dont l'alignement par rapport aux composants disposés sur la face avant, est particulièrement délicat, elle génère des problèmes d'enrobage de la puce par la résine, en raison de la présence de ces cavités relativement importantes dans le substrat. Une autre solution préconisée consiste à retirer complètement le substrat de silicium et à le remplacer par un substrat de verre. Cette solution présente également de très nombreux inconvénients, notamment en raison de la différence des coefficients de dilatation du silicium et du verre, de la fragilité du substrat et de la difficulté de soudage et d'enrobage de la puce par la résine.

Il a par ailleurs été proposé dans un article de Y.H. Xie et autres, intitulé "An Approach For Fabricating High Performance Inductors On Low Resistivity Substrates", IEEE BCTM 5.3, Septembre 1997, pp. 88-91, de réaliser un circuit inductif sur un substrat de silicium en partie poreux, de façon à augmenter sa résistivité. Plus précisément, on fait subir à un substrat de silicium, ayant typiquement une épaisseur de 300 microns, une oxydation anodique dans une solution aqueuse d'acide fluorhydrique ayant une concentration de 20% en volume avec une densité de courant anodique égale à 50 mA/cm², de façon à rendre poreuse une épaisseur de silicium comprise entre 50 et 250 microns. Une couche isolante de dioxyde de silicium est ensuite déposée sur la surface supérieure du substrat et recouverte d'une spirale métallique de façon à former le circuit inductif.

Cependant, le procédé décrit dans ce document de l'art antérieur ne s'applique qu'à la seule réalisation d'un circuit inductif et ne peut pas convenir à la réalisation simultanée, sur le même substrat de silicium poreux, d'autres composants actifs, par exemple des transistors bipolaires et/ou des transistors complémentaires à effet de champ à grilles isolées (transistors CMOS), en particulier ceux nécessaires à la réalisation des autres éléments d'un amplificateur accordé radiofréquence intégré. En effet, ce document indique que la surface interne des pores du silicium poreux est une source importante de contamination, notamment pour les ambiances gazeuses des fours qui seraient utilisées pour réaliser sur ce même substrat de silicium poreux lesdits transistors bipolaires ou CMOS. Et, outre ces problèmes de contamination, le silicium poreux subit des déformations de surface en température, ce qui est particulièrement inadapté pour la réalisation, postérieurement à cette phase de transformation de silicium en silicium poreux, des transistors bipolaires et/ou CMOS.

L'invention vise à apporter une solution plus satisfaisante à ces problèmes.

Un but de l'invention est de proposer de diminuer les pertes par courant de Foucault dans le substrat sous-jacent d'un circuit inductif réalisé de façon intégrée au sein d'un circuit intégré comportant également des transistors intégrés, ce circuit intégré étant réalisé sur une plaquette semiconductrice de silicium. Le coefficient de qualité du circuit inductif est alors augmenté.

L'invention propose donc un procédé de diminution des pertes par courant de Foucault d'un circuit inductif réalisé sur une plaquette semiconductrice de silicium incorporant également des transistors intégrés, procédé dans lequel on place la face arrière de la plaquette incorporant déjà sur sa face avant lesdits transistors et le circuit inductif, au contact d'un électrolyte acide contenant de l'acide fluorhydrique et au moins un autre acide, et on effectue une oxydation anodique du silicium de la plaquette en face arrière de façon à transformer ce silicium en silicium poreux sur une hauteur (épaisseur) prédéterminée depuis ladite face arrière en contact avec ledit électrolyte.

En d'autres termes, selon l'invention, on effectue la transformation du silicium du substrat en silicium poreux après que ce substrat ait subi tous les traitements classiques de réalisation des transistors et des différents circuits (par exemple en utilisant une technologie classique CMOS ou BiCMOS (Bipolaire-CMOS)). On effectue donc un traitement a posteriori du silicium, sur une plaquette déjà équipée en face avant des différents circuits intégrés contenant les différents transistors et circuits inductifs, par opposition à une transformation préliminaire de silicium en silicium poreux effectuée sur une plaquette vierge.

Ceci étant, l'épaisseur des plaquettes semiconductrices habituellement utilisées est de l'ordre de plusieurs centaincs de microns. Or, les électrolytes habituellement utilisés pour procéder à des oxydations anodiques de silicium ont des concentrations d'acide fluorhydrique généralement inférieures à 35% et contiennent en outre de l'éthanol qui constitue un agent tensio-actif permettant de diminuer la tension de surface de l'électrolyte favorisant ainsi l'élimination des bulles d'hydrogène résultant de l'oxydation anodique dans le but d'obtenir une meilleure homogénéité de l'attaque du silicium. Cependant, avec de tels électrolytes, les valeurs de densité anodique de courant applicables doivent rester suffisamment faibles afin d'éviter le phénomène d'électropolissage du silicium qui conduit à une érosion du substrat.

Il en résulte donc des vitesses de conversion de silicium en silicium poreux plus faibles que 10 microns/minute ce qui conduit, pour des épaisseurs importantes de plaquette, à une immersion de la face arrière de celle-ci pendant un temps extrêmement long, typiquement plus d'une heure, avec le risque d'une dissolution chimique du silicium d'autant plus importante que la valeur du pH de l'électrolyte est élevée.

L'invention prévoit donc d'effectuer l'oxydation anodique dans un électrolyte comportant de l'acide fluorhydrique et au moins un autre acide de façon à diminuer la valeur du pH de l'électrolyte et pouvoir ainsi augmenter la densité de courant anodique, et par conséquent la vitesse de conversion de silicium en silicium poreux, tout en diminuant le risque de dissolution chimique du silicium.

A cet égard, tout acide peut être employé et notamment de l'acide chlorhydrique ou de l'acide sulfurique.

En théorie, on pourrait évacuer les bulles d'hydrogène par une forte agitation mécanique de l'électrolyte. Cependant, une telle solution est moins efficace et peut conduire à des inhomogénéités d'attaque et par conséquent à une moins bonne amélioration du coefficient de qualité. C'est la raison pour laquelle, dans certaines applications, il est particulièrement préférable d'adjoindre à l'électrolyte un agent tensio-actif.

Et, il est particulièrement avantageux à cet égard d'utiliser comme autre acide de l'acide acétique. En effet, il a été observé que l'acide acétique constituait également un bon agent tensio-actif permettant de diminuer la tension de surface de l'électrolyte et donc de favoriser l'élimination des bulles d'hydrogène résultant de l'oxydation anodique.

L'invention est à cet égard remarquable par le fait que l'acide acétique permet d'une part, en combinaison avec l'acide fluorhydrique, de diminuer le pH de l'électrolyte autorisant par conséquent l'augmentation de la densité de courant anodique jusqu'à des valeurs par exemple aussi élevées que 300 mA/cm², tout en évitant le phénomène d'électropolissage, et évite d'autre part l'emploi d'éthanol qui aurait justement pour conséquence d'augmenter le pH (c'est-à-dire de diminuer l'acidité) ce qui irait dans le sens contraire de l'effet recherché.

On pourra par exemple utiliser une concentration d'acide fluorhydrique d'au moins de l'ordre de 40% en poids à laquelle on pourra adjoindre de l'acide acétique en une concentration de l'ordre de 5% en poids. On notera ici que les qualités tensio-actives de l'acide acétique étant très bonnes, seul un faible pourcentage en poids peut être utilisé.

D'une façon générale, on peut choisir avantageusement le pH de l'électrolyte ainsi que la valeur de la densité de courant anodique de façon à obtenir, sans électropolissage du silicium, une vitesse de formation de silicium poreux supérieure à 10 microns/mn avec une porosité finale inférieure à 70% en volume de vide.

En effet, il a été observé qu'une valeur de porosité finale supérieure à 70% en volume pouvait conduire à une fragilisation plus importante du substrat.

On pourra par exemple utiliser un électrolyte dont le pH est inférieur à 1, par exemple voisin de zéro, voire négatif, avec une densité de courant anodique au moins égale à 150 mA/cm², par exemple égale à 300 mA/cm². Ainsi, à titre d'exemple, un électrolyte formé d'une solution aqueuse contenant 40% en poids d'acide fluorhydrique et 5% en poids d'acide acétique conduit, avec une densité de courant anodique de 300 mA/cm², à une vitesse de croissance du silicium poreux de l'ordre de 20 microns/mn et à une porosité finale de l'ordre de 60% en volume de vide.

Une telle vitesse de croissance peut être également obtenue avec un électrolyte formé d'une solution aqueuse d'acide fluorhydrique à une concentration de 45% en poids, à laquelle on a ajouté de l'acide acétique à une concentration inférieure à 5%, et à laquelle on a également ajouté une faible quantité d'un autre acide, par exemple de l'acide chlorhydrique.

Une autre caractéristique de l'invention réside dans le fait que la transformation du silicium en silicium poreux doit s'effectuer sur une hauteur (épaisseur) prédéterminée, et ce notamment dans le but d'éviter une attaque de la couche de silicium disposée au voisinage de la face avant de la plaquette, et dans laquelle sont réalisées les différentes zones actives des autres composants, tels que les transistors. Alors qu'il serait possible de déterminer cette hauteur de silicium poreux en stoppant l'oxydation anodique après une durée prédéterminée compte tenu de la vitesse de croissance du silicium poreux mesurée par exemple lors d'une phase d'étalonnage, il est particulièrement avantageux de mesurer la différence de potentiel (tension) entre l'anode et une autre électrode disposée dans l'électrolyte (la cathode ou une autre électrode de référence) et d'utiliser cette mesure de différence de potentiel pour déterminer l'instant d'arrêt de l'oxydation anodique. Plus précisément, on effectue cette oxydation anodique en appliquant un courant anodique constant. On stoppe alors avantageusement ladite oxydation anodique lorsqu'on détecte une augmentation de la différence de potentiel.

En effet, les transistors réalisés comportent généralement des couches enterrées ayant un dopage élevé, par exemple du type N⁺, ou bien des zones implantées de type N. Par ailleurs, on peut également trouver dans le substrat, des zones d'isolement de type P⁺, permettant d'isoler deux transistors adjacents. Et, lorsque la plaquette est par exemple du silicium de type P, il se produit une augmentation de la résistance au niveau d'une jonction P-N ou d'une jonction P-P⁺. En conséquence, puisqu'on travaille à courant constant, une augmentation de la différence de potentiel entre l'anode et ladite autre électrode, signifie que l'électrolyte a atteint la jonction PN et qu'il convient alors d'arrêter cette oxydation anodique.

L'utilisation de ce silicium poreux obtenu tel quel après l'oxydation anodique, permet déjà une augmentation notable du coefficient de qualité. Ceci étant, il peut être souhaitable, dans certains cas, de stabiliser le silicium poreux par une oxydation et éviter ainsi d'éventuelles modifications du matériau.

On connaît déjà des traitements de stabilisation utilisant une oxydation thermique modérée. Cependant, en raison de la présence des circuits (transistors et autres) déjà réalisés sur la plaquette, le choix de la température s'avère particulièrement critique, car celle-ci doit être suffisamment faible pour ne pas endommager lesdits circuits mais également pour prévenir toute contamination des fours d'oxydation. C'est la raison pour laquelle, l'invention propose d'effectuer, postérieurement à l'étape de formation de silicium poreux, un traitement de stabilisation du silicium poreux par une oxydation chimique ou électrochimique.

Outre l'application aux circuits inductifs réalisés de façon intégrée sur silicium, et qui vient d'être évoquée, d'autres applications de l'invention peuvent être envisagées comme notamment la réalisation au sein d'un substrat de silicium, de zones isolantes particulièrement épaisses formées de silicium poreux oxydé, et permettant ainsi d'isoler certaines régions du substrat par rapport à d'autres.

L'invention propose donc également un procédé de formation de silicium poreux dans un substrat de silicium par oxydation anodique dudit substrat au contact d'un électrolyte acide contenant de l'acide fluorhydrique. Selon une caractéristique générale de l'invention, l'électrolyte contient en outre au moins un autre acide, et avantageusement de l'acide acétique qui constitue alors à la fois ledit autre acide et également un agent tensio-actif.

D'autres avantages et caractéristiques de l'invention apparaîtront à l'examen de la description détaillée d'un mode de mise en oeuvre, nullement limitatif et des dessins annexés sur lesquels :
- la figure 1 est une vue schématique de la face avant d'une plaquette de silicium,
- la figure 2 illustre schématiquement une partie d'une tranche de ladite plaquette qui va subir, selon le procédé selon l'invention, une oxydation anodique en face arrière au contact d'un électrolyte acide, et
- la figure 3 illustre schématiquement une cellule électrochimique permettant une mise en oeuvre du procédé selon l'invention.

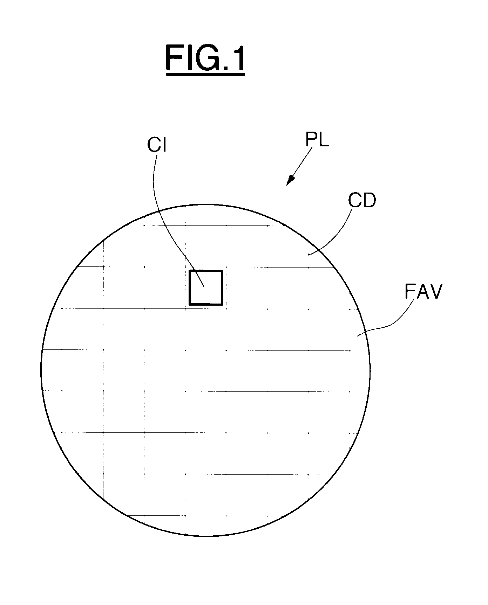

Sur la figure 1, la référence PL désigne une plaquette semiconductrice circulaire de silicium, ayant par exemple un diamètre de 200 mm, et ayant typiquement une épaisseur de l'ordre de 500 microns. Les différents circuits intégrés (puces) CI sont réalisés sur des zones prédéterminées de la face avant FAV de cette plaquette semiconductrice PL, et ces zones sont délimitées par des chemins de découpe CD le long desquels la plaquette sera ultérieurement sciée pour séparer mutuellement les circuits intégrés réalisés.

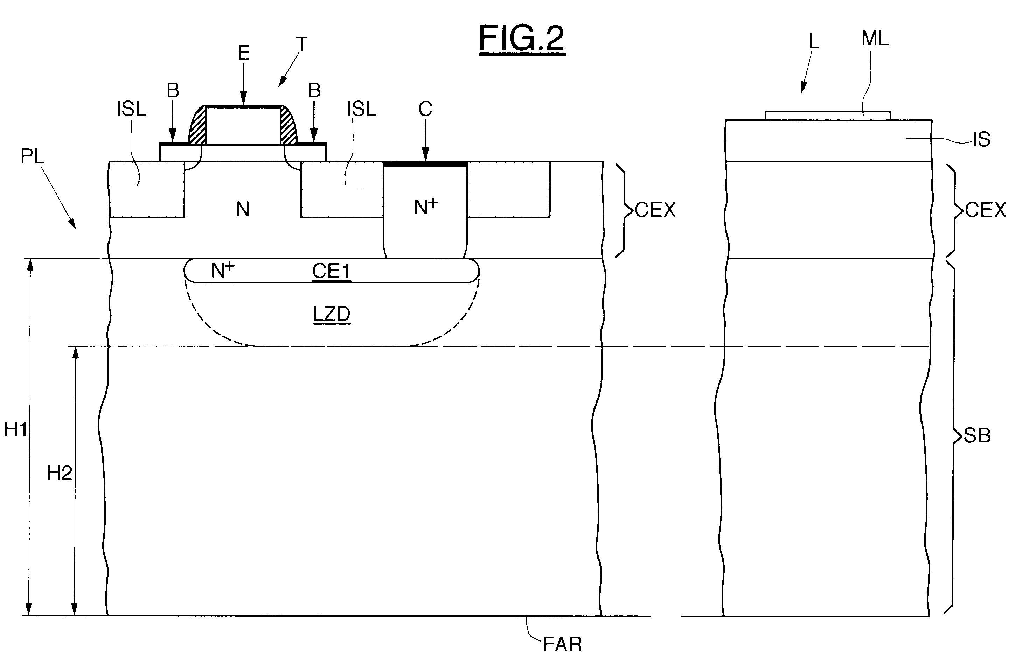

On suppose ici que chaque circuit intégré CI comporte des transistors bipolaires et/ou CMOS ainsi que des circuits inductifs. Sur la figure 2, on a représenté à des fins de simplification un seul transistor bipolaire T et un seul circuit inductif L.

Plus précisément, dans l'exemple illustré, non limitatif, la formation du transistor bipolaire T comporte une épitaxie d'une couche CEX de silicium de type N sur la surface supérieure du substrat initial de silicium SB au sein duquel on a préalablement implanté une couche enterrée CE1 de type N⁺.

On a ensuite réalisé des zones d'isolement latéral ainsi qu'un puits collecteur déporté C. La base B a ensuite été épitaxiée sur le collecteur intrinsèque et l'émetteur E a été formé.

Le circuit inductif L résulte par exemple de la formation sur la couche épitaxiée CEX d'une couche isolante épaisse IS, typiquement de l'ordre de 1000 Å, surmontée d'une spirale métallique ML obtenue par gravure d'un niveau de métallisation du circuit intégré.

Bien entendu, on aurait pu envisager la réalisation des zones actives des transistors non pas par épitaxie mais par implantation des zones correspondantes dans le substrat initial SB. Dans ce cas, la couche isolante IS supportant la métallisation ML du circuit inductif L reposerait directement sur le substrat SB de type P.

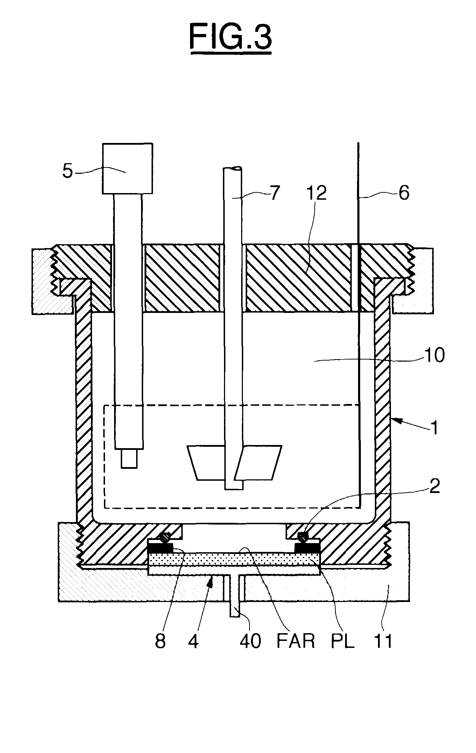

La plaquette PL comportant le circuit intégré réalisé est ensuite placée dans une cellule électrochimique, par exemple du type de celle illustrée schématiquement sur la figure 3.

Cette cellule électrochimique comporte une cuve 1 contenant un électrolyte 10 en contact avec la face arrière FAR de la plaquette PL. Cette plaquette PL est prise en sandwich entre une plaque métallique 4 au contact de la face avant de la plaquette, et un joint périphérique 2 au contact de la face arrière de la plaquette et reposant sur un décrochement de paroi de la cuve.

Dans le cas où l'on ne souhaiterait procéder qu'à une oxydation anodique de la zone centrale de la face arrière de la plaquette PL, par exemple parce que les circuits intégrés contenant les circuits inductifs ne sont localisés que dans cette zone centrale, on pourrait alors intercaler entre le joint et la face arrière de la plaquette un masque 8.

La plaque métallique 4 est fixée sur le bas de la cuve par l'intermédiaire d'un bouchon fileté 11 comportant un orifice central permettant le passage d'un plot (40) pour une prise de contact électrique.

Cette plaque métallique constitue l'anode. Cette anode doit être en contact électrique avec le substrat de silicium sous-jacent. A cet égard, une façon de réaliser un tel contact métallique consiste à utiliser les plots de contact substrat existant dans tous les circuits intégrés réalisés et qui relient le substrat de silicium sous-jacent à la surface du circuit intégré. On peut alors par exemple court-circuiter tous les contacts de substrat en utilisant une couche métallique, par exemple une pâte d'argent, qui pourra être ensuite facilement retirée par une dissolution dans un solvant organique, une fois l'oxydation anodique terminée. On pourrait utiliser également à la place de la pâte d'argent le dernier niveau de métallisation avant gravure.

Bien entendu, toute autre technique classique peut être utilisée pour réaliser ce contact anodique, par exemple une technique classique basée sur l'utilisation d'un contact électrolytique anodique.

La cathode est constituée ici d'une grille de platine 6 immergée dans l'électrolyte 10 et débouchant à l'extérieur de la cuve par un orifice ménagé dans le bouchon de fermeture supérieure 12 de cette cuve.

On prévoit également avantageusement un agitateur mécanique 7 et une autre électrode 5 immergée dans l'électrolyte, et servant d'électrode de référence. Bien que ceci ne soit pas représenté sur la figure 3 à des fins de simplification, cette électrode de référence peut être ainsi disposée au plus près de la face arrière de la plaquette de façon à obtenir, comme on le verra plus en détail ci-après, une plus grande précision dans la mesure de la différence de potentiel mesurée entre l'anode 4 et cette électrode de référence 5.

Selon un mode de mise en oeuvre du procédé selon l'invention, on utilise un électrolyte 10 formé d'une solution aqueuse d'acide fluorhydrique et d'acide acétique. La concentration d'acide fluorhydrique est de 40% en poids tandis que celle d'acide acétique est de 5% en poids. Le pH d'un tel électrolyte est alors inférieur à 0,1 On applique une tension entre l'anode et l'électrode de façon à faire circuler un courant anodique constant correspondant à une densité de courant anodique égale à 300 mA/cm². La vitesse de conversion du silicium en silicium poreux est alors de l'ordre de 20 microns/minute et la porosité finale obtenue est de l'ordre de 60%.

Bien que l'acide acétique constitue un très bon agent tensio-actif, on peut éventuellement, pour faciliter encore l'évacuation des bulles d'hydrogène, procéder à une faible agitation mécanique à l'aide de l'agitateur 7.

On poursuit l'oxydation anodique jusqu'à ce que la hauteur de silicium poreux, comptée depuis la face arrière FAR, atteigne la valeur H2 (figure 2). En effet, bien que l'on ait représenté, à des fins de simplification, une couche relativement mince CE1 dopée N⁺, l'homme du métier sait que la zone effectivement dopée LZD s'étend plus en profondeur dans le substrat avec un profil de dopage décroissant au fur et à mesure que l'on s'enfonce dans le substrat. La hauteur H2 correspond donc à la limite de dopage N, c'est-à-dire à l'apparition de la jonction PN. A ce moment là, la résistance augmente ce qui se traduit, puisqu'on travaille à courant constant, par une augmentation de la tension entre l'anode et l'électrode. On stoppe alors l'oxydation anodique en coupant le courant.

Ainsi, on obtient finalement une zone de silicium poreux s'étendant sur une hauteur H2. Même si la différence entre la hauteur H1 (hauteur initiale de la plaquette PL ou substrat SB) et la hauteur H2 est de l'ordre de quelques dizaines de microns, on obtient un silicium poreux s'étendant sur plusieurs centaines de microns ce qui conduit déjà à une amélioration sensible du coefficient de qualité, typiquement une augmentation de 50%. On garantit en outre une non-destruction des autres composants actifs réalisés sur le circuit intégré.

Un autre électrolyte utilisable, permettant une vitesse de croissance également de l'ordre de 20 microns/minute avec une porosité finale de l'ordre de 60%, peut consister en une solution aqueuse d'acide fluorhydrique à une concentration de 45% en poids, d'acide acétique à une concentration inférieure à 5% en poids, et d'une petite quantité d'un autre acide, par exemple de l'acide chlorhydrique à une concentration de 1 mole par litre. Le pH d'un tel électrolyte est alors inférieur à 0,01.

D'autres électrolytes acides peuvent être employés en utilisant par exemple de l'acide fluorhydrique et tout autre acide, tel que l'acide sulfurique, en combinaison de préférence avec de l'acide acétique. D'une façon générale, on peut choisir le pH de l'électrolyte ainsi que la valeur de densité de courant anodique de façon à obtenir, sans électropolissage du silicium, une vitesse de formation de silicium poreux supérieure à 10 microns/minute. Les valeurs limites de densité de courant anodique, compte tenu notamment du pH de l'électrolyte, permettant d'éviter un électropolissage du silicium, sont bien connues de l'homme du métier et ont en fait l'objet de nombreuses publications comme par exemple la thèse de Claude BERTRAND intitulée "Préparation et caractérisation du silicium poreux obtenu sur substrats P et N", soutenue le 10 Avril 1986 et disponible à l'Institut National Polytechnique de Grenoble (France).

Une Ibis cette oxydation anodique terminée, on procède avantageusement à une stabilisation du silicium poreux obtenu, par une oxydation chimique ou électrochimique. Si l'on utilise une oxydation chimique, on peut disposer le silicium poreux dans une solution 4/4/2 en volume de SO4H2/H2O2/CH3COOH (acide sulfurique/peroxyde d'hydrogène/acide acétique) pendant une durée de l'ordre de 10 minutes.

Pour une oxydation électrochimique (oxydation anodique) on disposera alors le silicium poreux dans une cellule électrochimique du type de celle illustrée sur la figure 3 contenant, comme électrolyte, une solution aqueuse de HCl à 1 mole/litre. Dans ce cas, la densité de courant anodique utilisée est de l'ordre de 10 mA/cm² pendant une durée de 15 minutes.

## Revendications

1. Procédé d'amélioration du coefficient de qualité d'un circuit inductif réalisé sur une plaquette semiconductrice (PL) de silicium incorporant également des transistors intégrés (T), dans lequel on place la face arrière (FAR) de la plaquette incorporant déjà sur sa face avant (FAV) lesdits transistors et le circuit inductif (L), au contact d'un électrolyte acide (10) contenant de l'acide fluorhydrique et au moins un autre acide, et on effectue une oxydation anodique du silicium de la plaquette en face arrière de façon à transformer ce silicium en silicium poreux sur une hauteur prédéterminée (H2) depuis ladite face arrière (FAR) en contact avec ledit électrolyte.

2. Procédé selon la revendication 1, caractérisé par le fait que l'électrolyte (10) contient également un agent tensio-actif et par le fait que ledit autre acide constitue également l'agent tensio-actif et est de l'acide acétique.

3. Procédé selon la revendication 1 ou 2, caractérisé par le fait que la concentration d'acide fluorhydrique est au moins de l'ordre de 40% en poids.

4. Procédé selon la revendication 1, 2 ou 3, caractérisé par le fait qu'on choisit le pH de l'electrolyte (10) ainsi que la valeur de la densité de courant anodique de façon à obtenir, sans électropolissage du silicium, une vitesse de formation de silicium poreux supérieure à 10 microns/minute avec une porosité finale inférieure à 70% en volume de vide.

5. Procédé selon l'une des revendications 1 à 4, caractérisé par le fait que le pH de l'électrolyte (10) est inférieur à 1 et par le fait que la densité de courant anodique est au moins égale à 150mA/cm².

6. Procédé selon l'une des revendications précédentes, caractérisé par le fait que l'on applique un courant anodique constant pour effectuer ladite oxydation anodique, par le fait que l'on mesure la différence de potentiel entre l'anode (4) et une autre électrode (5) disposée dans l'électrolyte, et par le fait que l'on stoppe ladite oxydation anodique lorsqu'on détecte une augmentation de ladite différence de potentiel.

7. Procédé selon l'une des revendications précédentes, caractérisé par le fait que, la plaquette semiconductrice comportant un substrat semiconducteur sous-jacent et des plots de contact avec le substrat, on applique ledit courant anodique par l'intermédiaire des plots de contact substrat, après avoir éventuellement court-circuiter tous les plots de contact substrat par une couche métallique.

8. Procédé selon l'une des revendications précédentes, caractérisé par le fait que, postérieurement à l'étape de formation de silicium poreux, on effectue un traitement de stabilisation du silicium poreux par oxydation chimique ou électrochimique.

9. Procédé de formation de silicium poreux dans un substrat de silicium par oxydation anodique dudit substrat (PL) au contact d'un électrolyte acide (10) contenant de l'acide fluorhydrique, caractérisé par le fait que l'électrolyte (10) contient en outre au moins un autre acide.

10. Procédé selon la revendication 9, caractérisé par le fait qu'on choisit les concentrations d'acide fluorhydrique et dudit autre acide de façon à appliquer des densités de courant anodique au moins égale à 150 mA/cm², par exemple de l'ordre de 300 mA/cm², tout en évitant l'électropolissage du silicium.

11. Procédé selon la revendication 9 ou 10, caractérisé par le fait que l'électrolyte (10) contient également un agent tensio-actif, et par le fait que ledit autre acide constitue également l'agent tensio-actif et est de l'acide acétique.

12. Procédé selon la revendication 11, caractérisé par le fait que la concentration d'acide fluorhydrique est au moins égale à 40% en poids et par le fait que la concentration d'acide acétique est de l'ordre de 5% en poids.
